(19) Europäisches Patentamt
European Patent Office
Office européen des brevets

(11) **EP 4 401 322 A1**

(12) **EUROPEAN PATENT APPLICATION**

(43) Date of publication:
**17.07.2024 Bulletin 2024/29**

(21) Application number: **24151253.2**

(22) Date of filing: **10.01.2024**

(51) International Patent Classification (IPC):
**H04B 1/04** *(2006.01)* **H03F 1/02** *(2006.01)*

(52) Cooperative Patent Classification (CPC):
**H04B 1/04;** H03F 1/0288; H04B 2001/0408;
H04B 2001/045

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 13.01.2023 US 202363479787 P
13.01.2023 US 202363479788 P
13.01.2023 US 202363479790 P
15.05.2023 US 202363502268 P
30.06.2023 US 202363511352 P
17.07.2023 US 202363513974 P
20.09.2023 US 202363539384 P
29.12.2023 US 202318400417

(71) Applicant: **Qorvo US, Inc.
Greensboro, NC 27409 (US)**

(72) Inventors:
• **SHAHVERDI, Amin
Greensboro 27409 (US)**
• **LANDON, Thomas
Greensboro 27409 (US)**
• **HAJJI, Rached
Greensboro 27409 (US)**
• **REESE, Elias
Greensboro 27409 (US)**

(74) Representative: **D Young & Co LLP
3 Noble Street
London EC2V 7BQ (GB)**

(54) **METHODS AND TECHNIQUES TO IMPROVE EFFICIENCY IN DOHERTY POWER AMPLIFIERS OPERATING WITH MODULATED RF SIGNAL OVER WIDE FREQUENCY BAND**

(57) A Doherty amplifier is disclosed. In some embodiments, the Doherty amplifier includes: a main amplifier defining a first trunk thickness; an auxiliary amplifier defining a second trunk thickness. Impedances of the Doherty amplifier are set by selecting the first trunk thickness of the main amplifier and the second trunk thickness of the auxiliary amplifier. In this manner, the power efficiency of the Doherty amplifier is improved when amplifying a modulated signal.

FIG. 1A

FIG. 1B

**EP 4 401 322 A1**

**Description**

Related Applications

This application claims the benefit of provisional patent application serial number 63/511,352, filed June 30, 2023, and claims the benefit of provisional patent application serial number 63/479,787, filed January 13, 2023, the disclosures of which are hereby incorporated herein by reference in their entireties.

This application claims the benefit of provisional patent application serial number 63/539,384, filed September 20, 2023, and claims the benefit of provisional patent application serial number 63/513,974, filed July 17, 2023, and claims the benefit of provisional patent application serial number 63/502,268, filed May 15, 2023, and claims the benefit of provisional patent application serial number 63/479,790, filed January 13, 2023, and claims the benefit of provisional patent application serial number 63/479,788, filed January 13, 2023, the disclosures of which are hereby incorporated herein by reference in their entireties.

Field

This disclosure relates generally to Doherty amplifiers formed in integrated circuit (IC) structures.

Background

Doherty amplifiers are popular for having high efficiency at average output power as well as maximum output power. A Doherty amplifier generally includes a main amplifier (also known as a carrier amplifier) and an auxiliary amplifier (also known as a peaking amplifier). The main and auxiliary amplifiers are biased differently, such that the main amplifier is always providing amplification to a radio frequency (RF) signal while the auxiliary amplifier only provides amplification once the RF signal reaches a particular power level. Doherty amplifiers typically show high efficiency when operating with continuous wave (CW) or pulsed-CW signal at specified average power. However, the efficiency of currently known Doherty amplifiers degrades when amplifying a wideband modulated RF signal (e.g., 5G NR signal with 600MHz bandwidth).

Summary

Particular aspects are set out in the appended independent claims. Various optional embodiments are set out in the dependent claims.

In some embodiments, an integrated circuit (IC) amplification device, including: a Doherty amplifier including: a main amplifier defining a first trunk thickness; an auxiliary amplifier defining a second trunk thickness; wherein: the first trunk $PAR$ thickness is set such that $1 \leq VSWR_{Z_{MOD}-Z_{EFFM}} \leq 1.3$ and such that $10^{\frac{PAR}{20}} - 0.3 \leq VSWR_{Z_{OPTM}-Z_{MOD}} \leq 10^{\frac{PAR}{20}} + 0.3$, where PAR is a peak to average ratio; the second trunk thickness is set such that $1 \leq VSWR_{Z_{EFFA}-Z_{POWA}} \leq 3$ and such that $1 \leq VSWR_{Z_{OPTA}-Z_{POWA}} \leq 1.7$. In some embodiments, the Doherty amplifier is configured to amplify a modulated signal having the PAR. In some embodiments, the first trunk thickness is set so that $Z_{MOD}$ and $Z_{EFFM}$ are substantially equal. In some embodiments, the first trunk thickness is set so that $Z_{OPTM}$ and $Z_{POWM}$ are substantially equal. In some embodiments, the first trunk thickness is set so that $Z_{MOD}$ and $Z_{EFFM}$ are substantially equal; and the first trunk thickness is set so that $Z_{OPTM}$ and $Z_{POWM}$ are substantially equal. In some embodiments, the main amplifier is formed by a field effect transistor including a gate; a passivation layer; a channel region; the gate being formed on the channel region and extending through the passivation layer, wherein the first trunk thickness is a thickness of the passivation layer. In some embodiments, the auxiliary amplifier is formed by a field effect transistor including a gate; a passivation layer; a channel region; the gate being formed on the channel region and extending through the passivation layer, wherein the second trunk thickness is a thickness of the passivation layer. In some embodiments, the main amplifier is formed by a first field effect transistor including a first gate; a first passivation layer; a first channel region; the first gate being formed on the first channel region and extending through the first passivation layer, wherein the first trunk thickness is a thickness of the first passivation layer; the auxiliary amplifier is formed by a field effect transistor including a second gate; a second passivation layer; a second channel region; and the second gate being formed on the second channel region and extending through the second passivation layer, wherein the second trunk thickness is a thickness of the second passivation layer. In some embodiments, the first field effect transistor is a first Gallium Nitride transistor and the second field effect transistor is a second Gallium Nitride transistor.

In some embodiments, the first trunk thickness is substantially between 700 and 1400 Angstroms and the second trunk thickness is between 700 and 1400 Angstroms. In some embodiments, a voltage standing wave ratio between $Z_{POWA}$ and $Z_{MOD}$ is set to approximately 2:1. In some embodiments, the Doherty amplifier is configured to receive a modulated signal with the PAR of 6 decibels. In some embodiments, the first trunk thickness is substantially between 200 and 600 Angstroms and the second trunk thickness is between 700 and 1400 Angstroms. In some embodiments, a voltage standing wave ratio (VSWR) between $Z_{POWA}$ and $Z_{MOD}$ is set to approximately 2.7:1. In some embodiments, the Doherty amplifier is configured to receive a modulated signal with a PAR of 8.6 decibels.

In some embodiments, an integrated circuit (IC) amplification device, Including a Doherty amplifier Including: a radio frequency (RF) input configured to receive an RF input signal; an RF output; a main amplifier defining a first trunk thickness, wherein the main amplifier has a main amplifier input and a main amplifier output, the main amplifier input is coupled to the RF input; an auxiliary amplifier defining a second trunk thickness, wherein the auxiliary amplifier has an auxiliary amplifier input and an auxiliary amplifier output, the auxiliary amplifier input being coupled to the RF input; a first quarter wave component connected between the RF input and the auxiliary amplifier input; a second quarter wave component connected between the main amplifier output and the RF output; wherein: the first trunk thickness is set such that $1 \leq VSWR_{Z_{MOD}\text{-}Z_{EFFM}} \leq 1.3$ and such that $10^{\frac{PAR}{20}} - 0.3 \leq VSWR_{Z_{OPTM}-Z_{MOD}} \leq 10^{\frac{PAR}{20}} + 0.3$,

where PAR is a peak to average ratio; the second trunk thickness is set such that $1 \leq VSWR_{Z_{EFFA}\text{-}Z_{POWA}} \leq 3$ and such that $1 \leq VSWR_{Z_{OPTA}\text{-}Z_{POWA}} \leq 1.7$.. In some embodiments, the main amplifier output and the auxiliary amplifier output are coupled to the RF output. In some embodiments, the Doherty amplifier is configured to amplify a modulated signal having PAR. In some embodiments, the first trunk thickness is set so that $Z_{MOD}$ and $Z_{EFFM}$ are substantially equal. In some embodiments, the first trunk thickness is set so that $Z_{OPTM}$ and $Z_{POWM}$ are substantially equal. In some embodiments, the second trunk thickness is set so that $Z_{OPTA}$ and $Z_{POWA}$ are substantially equal.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

Brief Description of the Drawing Figures

The accompanying drawing figures incorporated in and forming a part of this specification illustrate several aspects of the disclosure, and together with the description serve to explain the principles of the disclosure.

FIG. 1A is a Doherty amplifier, in accordance with some embodiments.
FIG. 1B is a Doherty amplifier, in accordance with some embodiments.
FIG. 2 shows a cross-sectional view of an example quasi-dual-gate field-effect transistor (FET) structure having a floating ohmic contact and a field plate 240, in accordance with some embodiments.
FIG. 3 shows a cross-sectional view of an example FET structure having a floating ohmic contact and a field plate, in accordance with some embodiments.
FIG. 4 is a graph demonstrating possible curves of efficiency versus output power for the Doherty amplifier when the RF signal is a continuous wave signal or a pulsed continuous wave signal along with dots demonstrating possibilities of the efficiency performance of the Doherty amplifier at the average power level $P_{avg}$, in accordance with some embodiments.
FIG. 5 is the complementary cumulative distribution function (CCDF) of a modulated signal (with peak-to-average ratio (PAR) of 10dB) plotted as a function of power, in accordance with some embodiments.
FIG. 6 illustrates another example of a graph illustrating the power efficiency of a Doherty amplifier, in accordance with some embodiments.
FIG. 7 illustrates LP contours of the main amplifier in FIG. 1A on a Smith chart, in accordance with some embodiments.
FIG. 8 illustrates LP contours of the auxiliary amplifier in FIG. 1A on a Smith chart, in accordance with some embodiments.
FIG. 9 illustrates the load impedance provided by an output matching network and a target load impedance for the Doherty amplifier on a Smith chart, in accordance with some embodiments.
FIG. 10 illustrates the optimum areas for $Z_{MOD}$ and $Z_{OPTM}$ for the main amplifier of FIG. 1A, in accordance with some embodiments.

FIG. 11 illustrates non-optimum load areas and FIG. 12 illustrates optimum load areas for the Doherty amplifier, shown in FIG. 1A.

FIG. 13 illustrates user elements, such as mobile terminals, smart watches, tablets, computers, navigation devices, access points, and like wireless communication devices that support wireless communications, such as cellular, wireless local area network (WLAN), Bluetooth, and near field communications.

Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

Note that relational terminology such as "substantially," "approximately," and/or the like should be interpreted objectively in accordance with the communication device and technological environment in which the Doherty amplifier is employed and, in addition, the performance parameters relevant to the operation of the Doherty amplifier for the particular application of the Doherty amplifier within the communication device (or at least one prospective communication device) and the technological environment (or at least one prospective technological environment). For example, if A is "substantially" equal to B or is between B and C, the statements are to be interpreted to be true within acceptable error ranges for the manufacturing techniques being employed and the technological environment in which the Doherty amplifier is being utilized.

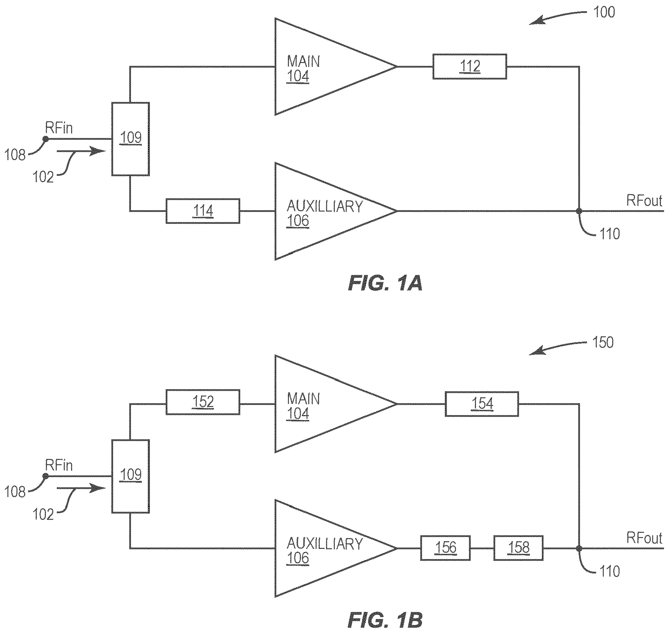

FIG. 1A is a Doherty amplifier 100, in accordance with some embodiments.

The Doherty amplifier 100 is an integrated circuit (IC) or a module amplification device. In some embodiments, the Doherty amplifier 100 is a noninverting Doherty amplifier.. The Doherty amplifier 100 is configured to amplify a radio frequency (RF) signal 102. The specific characteristics of the Doherty amplifier 100 may vary in accordance with the communication device and technological environment in which the Doherty amplifier 100 is employed and, in addition, the performance parameters relevant to the operation of the Doherty amplifier 100 for the particular application(s) of the Doherty amplifier 100 within the communication device (or prospective communication device(s)) and the technological environment (or prospective technological environment(s)). It should be noted that the Doherty amplifier 100 may be configured for operation in any suitable communication device and technological environment. Thus, the RF signal 102 may be any type of RF signal. In some embodiments, the Doherty amplifier is particularly useful when the RF signal 102 is a modulated RF signal. The amplification techniques explained below are particularly useful so that a main amplifier 104 and an auxiliary amplifier 106 in the Doherty amplifier 100 maintain high efficiency with a modulated RF signal over wide frequency band. In some embodiments, the RF signal 102 may be multiplexed using time division multiplexing (TDM), frequency division multiplexing (FDM), space division multiplexing (SDM), code division multiple access (CDMA) multiplexing, orthogonal frequency division multiple access (OFDMA) multiplexing, and/or the like. In some embodiments, the Doherty amplifier 100 may be configured to provide amplification for the RF signal 102 if the RF signal 102 is formatted in accordance with 2G Global System for Mobile Communications (GSM) standards, 3G standards, 4G Long Term Evolution (LTE) standards, 5G standards, 5G NR standards, 6G standards, and/or the like.

In this embodiment, the RF signal 102 may be an RF uplink signal for uplink to a base station from a mobile communication device (e.g., smartphone, tablet, laptop, etc.). The Doherty amplifier 100 may be within the mobile communication device and the mobile communication device may be using the Doherty amplifier 100 to amplify the RF signal 102 for transmission by an antenna (not shown). Alternatively, the Doherty amplifier 100 may be within the base station. Thus, the base station may be using the Doherty amplifier 100 for amplification upon reception of the RF signal 102 from the mobile communication device. In another embodiment, the RF signal 102 may be an RF downlink signal for downlink to the mobile communication device (e.g., smartphone, tablet, laptop, etc.) from the base station. In this case, the mobile communication device may be using the Doherty amplifier 100 to amplify the RF signal 102 after reception from the base station. Alternatively, the base station may be using the Doherty amplifier 100 to amplify the RF signal 102 for transmission by an antenna (not shown) to the mobile communication device.

To amplify the RF signal 102, the Doherty amplifier 100 includes the main amplifier 104 and the auxiliary amplifier 106. While a signal level of the RF signal 102 is below a threshold level, the auxiliary amplifier 106 is deactivated and the main amplifier 104 provides all of the amplification to the RF signal 102. In some embodiments, the threshold level corresponds with an average power level of amplification. The RF signal 102 may be any type of RF signal depending on the type of communication device (e.g., smartphone, tablet, laptop, base station, etc.) in which the Doherty amplifier 100 is provided and the amplification operation being provided by the Doherty amplifier 100. The main amplifier 104 is configured to amplify the RF signal 102 in accordance with a main amplifier gain of the main amplifier 104. So long as the main amplifier 104 is within a linear operating range (i.e., not saturated and below a compression point), the auxiliary amplifier 106 is deactivated. In some embodiments, the main amplifier 104 is biased so as to be a class AB amplifier or a class B amplifier.

Referring again to the Doherty amplifier 100 shown in FIG. 1A, the output impedance of the auxiliary amplifier 106 is very high and the auxiliary amplifier 106 appears like an open circuit with respect to the main amplifier 104 while the main amplifier 104 is activated and the auxiliary amplifier 106 is deactivated. However, the auxiliary amplifier 106 is configured to activate in response to the signal level of the RF signal 102 reaching a threshold level (e.g., the signal level corresponding to the average power level). The Doherty amplifier 100 is configured such that the main amplifier 104 remains activated while the auxiliary amplifier 106 is activated. In some embodiments, the main amplifier 104 may be held at or near its peak power level (i.e., saturation). In general, this peak power level occurs just prior to the 3dB compression point (i.e., a knee voltage) of the main amplifier 104 and thus when the main amplifier 104 is nearly saturated.

However, it should be noted that some embodiments of the Doherty amplifier 100 may hold the main amplifier 104 at backed-off power levels while the auxiliary amplifier 106 is activated. If the Doherty amplifier 100 holds the main amplifier 104 at backed-off power levels while the auxiliary amplifier 106 is activated, a control circuit may be configured to reduce or prevent power-efficiency degradations in the Doherty amplifier 100 due to the main amplifier 104 operating at power levels backed off from the 3dB compression point. This is typically desirable for modern communication systems. In some embodiments, the auxiliary amplifier 106 is biased as a class C amplifier.

The Doherty amplifier 100 includes an RF input 108, an RF output 110, a quarter wave component 112, and a quarter wave component 114. The RF signal 102 is received by the Doherty amplifier 100 at the RF input 108. The RF input 108 is connected to a splitter 109. The input of the main amplifier 104 is connected to one of the splitter output terminals of the splitter 109. The input of the auxiliary amplifier 106 is coupled to the other splitter output terminal of the splitter 108. Both the main amplifier input of the main amplifier 104 and the auxiliary amplifier input of the auxiliary amplifier 106 are coupled to the RF input 108 through the splitter 109. In some embodiments, the RF input 108 is a node, a pin, a terminal, a port, a contact, a conductive pillar, a trace, or any other component capable of receiving the RF signal 102. Both the main amplifier output of the main amplifier 104 and the auxiliary amplifier output of the auxiliary amplifier 106 are coupled to the RF output 110. In some embodiments, the RF input 108 is a node, a pin, a terminal, a port, a contact, a conductive pillar, a trace, or any other component capable of transmitting the RF signal 102 to a load.

The quarter wave component 112 is coupled between the main amplifier output of the main amplifier 104 and the RF output 110. The quarter wave component 112 is configured to provide a 90 degree phase shift. In some embodiments, the quarter wave component 112 is a quarter wave transmission line transformer. In some embodiments, the quarter wave component 112 is a quadrature coupler. The quarter wave component 114 is coupled between the RF input 108 and the auxiliary amplifier input of the auxiliary amplifier 106. The quarter wave component 114 is configured to provide a 90 degree phase shift. In some embodiments, the quarter wave component 114 is a quarter wave transmission line transformer. In some embodiments, the splitter 109 and the quarter wave component 114 are, collectively, a quadrature coupler.

While the auxiliary amplifier 106 is deactivated, the main amplifier 104 is the only amplifier that provides amplification to the RF signal 102. The quarter wave component 112 provides a 90 degree phase shift to the amplified RF signal 102. However, once the auxiliary amplifier 106 is activated, the RF signal 102 is split at the RF input 108. In some embodiment, the RF input 108 is split evenly. In other embodiments, the RF signal 102 is not split evenly. At the main amplifier input and the auxiliary amplifier input, the split RF signals are out of phase. However, split RF signals are brought back into phase and reactively combined by the quarter wave components 114 and 112.

FIG. 1B is a Doherty amplifier 150, in accordance with some embodiments.

The Doherty amplifier 150 is an integrated circuit (IC) or a module amplification device. In some embodiments, the Doherty amplifier 150 is an inverting Doherty amplifier.. The Doherty amplifier 150 is configured to amplify the RF signal 102. The specific characteristics of the Doherty amplifier 150 may vary in accordance with the communication device and technological environment in which the Doherty amplifier 150 is employed and, in addition, the performance parameters relevant to the operation of the Doherty amplifier 150 for the particular application(s) of the Doherty amplifier 150 within the communication device (or prospective communication device(s)) and the technological environment (or prospective technological environment(s)). It should be noted that the Doherty amplifier 150 may be configured for operation in any suitable communication device and technological environment.

The Doherty amplifier 150 includes the RF input 108, the RF output 110, the main amplifier 104 and the auxiliary amplifier 106 described above with respect to FIG. 1A. To amplify the RF signal 102, the Doherty amplifier 150 includes the main amplifier 104 and the auxiliary amplifier 106. While a signal level of the RF signal 102 is below a threshold level, the auxiliary amplifier 106 is deactivated and the main amplifier 104 provides all of the amplification to the RF signal 102. In some embodiments, the threshold level corresponds with an average power level of amplification. The RF signal 102 may be any type of RF signal depending on the type of communication device (e.g., smartphone, tablet, laptop, base station, etc.) in which the Doherty amplifier 150 is provided and the amplification operation being provided by the Doherty amplifier 150. The main amplifier 104 is configured to amplify the RF signal 102 in accordance with a main amplifier gain of the main amplifier 104. So long as the main amplifier 104 is within a linear operating range (i.e., not saturated and below a compression point), the auxiliary amplifier 106 is deactivated. In some embodiments, the main amplifier 104 is biased so as to be a class AB amplifier or a class B amplifier.

Referring again to the Doherty amplifier 150 shown in FIG. 1B, the output impedance of the auxiliary amplifier 106 is very high and the auxiliary amplifier 106 appears like an open circuit with respect to the main amplifier 104 while the main amplifier 104 is activated and the auxiliary amplifier 106 is deactivated. However, the auxiliary amplifier 106 is configured to activate in response to the signal level of the RF signal 102 reaching a threshold level (e.g., the signal level corresponding to the average power level). The Doherty amplifier 150 is configured such that the main amplifier 104 remains activated while the auxiliary amplifier 106 is activated. In some embodiments, the main amplifier 104 may be held at or near its peak power level (i.e., saturation). In general, this peak power level occurs just prior to the 3dB compression point (i.e., a knee voltage) of the main amplifier 104 and thus when the main amplifier 104 is nearly saturated.

However, it should be noted that some embodiments of the Doherty amplifier 150 may hold the main amplifier 104 at backed-off power levels while the auxiliary amplifier 106 is activated. If the Doherty amplifier 150 holds the main amplifier 104 at backed-off power levels while the auxiliary amplifier 106 is activated, a control circuit may be configured to reduce or prevent power-efficiency degradations in the Doherty amplifier 150 due to the main amplifier 104 operating at power levels backed off from the 3dB compression point. This is typically desirable for modern communication systems. In some embodiments, the auxiliary amplifier 106 is biased as a class C amplifier.

The Doherty amplifier 150 includes a quarter wave component 152, and a quarter wave component 154, a matching network 156, and a delay component 158. The RF signal 102 is received by the Doherty amplifier 150 at the RF input 108. The RF input 108 is connected to a splitter 109. The input of the main amplifier 104 is connected to one of the splitter output terminals of the splitter 109. The input of the auxiliary amplifier 106 is coupled to the other splitter output terminal of the splitter 109. Both the main amplifier input of the main amplifier 104 and the auxiliary amplifier input of the auxiliary amplifier 106 are coupled to the RF input 108 through the splitter 109. In some embodiments, the RF input 108 is a node, a pin, a terminal, a port, a contact, a conductive pillar, a trace, or any other component capable of receiving the RF signal 102. Both the main amplifier output of the main amplifier 104 and the auxiliary amplifier output of the auxiliary amplifier 106 are coupled to the RF output 110. In some embodiments, the RF input 108 is a node, a pin, a terminal, a port, a contact, a conductive pillar, a trace, or any other component capable of transmitting the RF signal 102 to a load.

The quarter wave component 152 is coupled between the main amplifier input of the main amplifier 104 and the corresponding output terminal of the splitter 109. The quarter wave component 152 is configured to provide a 90 degree phase shift. In some embodiments, the quarter wave component 152 is a quarter wave transmission line transformer. In some embodiments, the splitter 109 and the quarter wave component 152 are, collectively, a quadrature coupler. The quarter wave component 154 is coupled between amplifier output of the main amplifier 104 and the RF output 110. The quarter wave component 154 is configured to provide a 90 degree phase shift. In some embodiments, the quarter wave component 154 is a quarter wave transmission line transformer. In some embodiments, the quarter wave component 154 is a quadrature coupler. The matching network 156 is coupled between the output terminal of the auxiliary amplifier 106 and the delay component 158. The delay component is coupled between the matching network 156 and the RF output 110. The matching network 156 and delay component 158 are configured to match the load impedance to the impedance of the auxiliary amplifier and provide the appropriate phase shift at the RF output node 110.

While the auxiliary amplifier 106 is deactivated, the main amplifier 104 is the only amplifier that provides amplification to the RF signal 102. The quarter wave component 152 provides a 90 degree phase shift to the amplified RF signal 102. However, once the auxiliary amplifier 106 is activated, the RF signal 102 is split at the RF input 108. In some embodiment, the RF input 108 is split evenly. In other embodiments, the RF signal 102 is not split evenly. At the main amplifier input and the auxiliary amplifier input, the split RF signals are out of phase. However, split RF signals are brought back into phase and reactively combined by the quarter wave components 154 and 156.

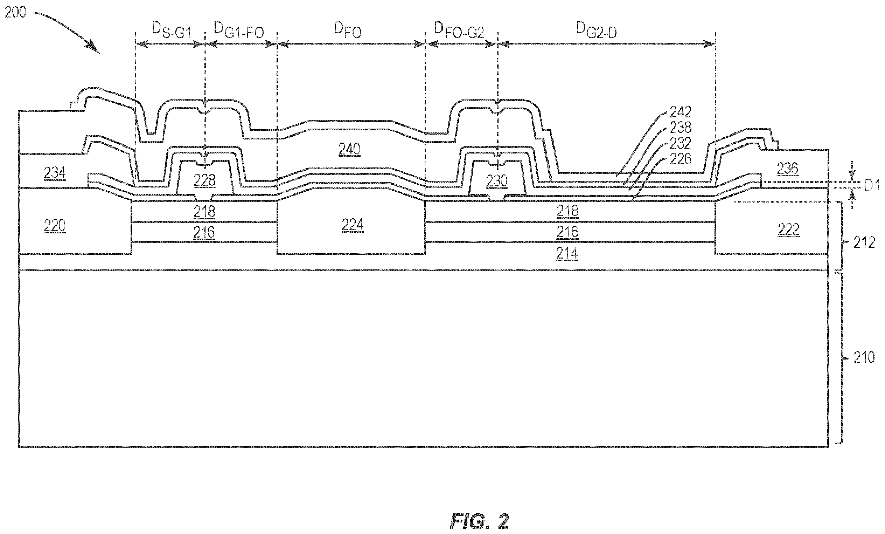

FIG. 2 shows a cross-sectional view of an example quasi-dual-gate field-effect transistor (FET) structure 200 having a floating ohmic contact 224 and a field plate 240, in accordance with some embodiments.

The quasi-dual-gate FET structure 200 is an IC structure. The main amplifier 104 shown in FIG. 1A and FIG. 1B is provided as one or more of the FETs shown in the FET structure 200, in accordance with some embodiments. For example, in some embodiments, a single one of the FETs is provided as the main amplifier 104. In other embodiments, multiple FETs are stacked and coupled in cascode to provide the main amplifier 104. It should be noted that in other embodiments, the FET is not a quasi-dual-gate structure as shown in FIG. 2 but rather is a single gate structure.

In The quasi-dual-gate FET structure 200 may be a high-electron-mobility transistor (HEMT), for example, a quasi-dual-gate HEMT, including a substrate 210 and a body region 212 and configured to implement a cascode function. The body region 212 is disposed over a top surface of the substrate 210 and comprises a buffer layer 214, a channel layer 216, and a barrier layer 218, wherein the barrier layer 218 extends over the channel layer 216, and the channel layer 216 is disposed over the buffer layer 214. In this manner, a top surface of the barrier layer 218 forms a top surface of the body region 212 and a bottom surface of the buffer layer 214 forms a bottom surface of the body region 212.

The quasi-dual-gate FET structure 200 further comprises a source ohmic contact 220, a drain ohmic contact 222, and a floating ohmic contact 224 that form over the top surface of the body region 212 and diffuse downward into the body region 212 by thermal annealing. Next, a first passivation layer 226 is deposited over an outermost surface of the body region 212, including top surfaces of the body region 212, the source ohmic contact 220, the drain ohmic contact 222, and the floating ohmic contact 224. Portions of the first passivation layer 226 are selectively removed, for example, using photolithography, to form contact surfaces into which a first gate electrode 228, a second gate electrode 230, a source electrode 234, and a drain electrode 236 are deposited. In this manner, the first gate electrode 228 and the second gate electrode 230 are formed in, over, and around selectively removed portions of the first passivation layer 226. In this configuration, the first gate electrode 228 forms between the source ohmic contact 220 and the floating ohmic contact 224, and the second gate electrode 230 forms between the floating ohmic contact 224 and the drain ohmic contact 222. A trunk thickness D1 of the main amplifier 104 (See FIG. 1A) refers to the thickness of the first passivation layer 226. Each of the portions of the body region 212 directly under the gate electrodes 228, 230 is a channel region. The trunk thickness D1 thus refers to the thickness of the dielectric material between a channel region and bottom on the connection structure for the gate electrodes 228, 230. In some embodiments, the trunk thickness D1 thus refers to the thickness of the first filed plate (i.e., Tcap) of the gate and bottom on the connection structure for the gate electrodes 228, 230. Each of the portions of the body region 212 directly under the gate electrodes 228, 230 is a channel region.

The quasi-dual-gate FET structure 200, as shown in FIG. 2, may further comprise a second passivation layer 232 that is deposited over a top surface of the first passivation layer 226, exposed portions of top surfaces of the source ohmic contact 220 and the drain ohmic contact 222, and over exposed surfaces of the first gate electrode 228 and the second gate electrode 230. Upon selective removal of portions of the second passivation layer 232 over top surfaces of the source ohmic contact 220 and the drain ohmic contact 222, through a lift-off or an etching process, metal material is deposited in, over, and around selectively removed portions of the second passivation layer 232 to form the source electrode 234 and the drain electrode 236.

As illustrated, a distance between the source electrode 234 and the first gate electrode 228 ($D_{S-G1}$) is measured horizontally, at least in this example, from an outer edge of the source electrode 334 to a middle point of the first gate electrode 228. In this regard, the distance between the source electrode 334 and the first gate electrode 228 ($D_{S-G1}$) may be any suitable value. Furthermore, a distance between the first gate electrode 228 and the floating ohmic contact 224 ($D_{G1-FO}$) is measured, horizontally, from the middle point of the first gate electrode 228 to an outer edge of the floating ohmic contact 224 over the top surface of the body region 212 that is closest to the first gate electrode 228. In this regard, the distance between the first gate electrode 228 and the floating ohmic contact 224 ($D_{G1-FO}$) may be any suitable value.

As shown in FIG. 2, the length of the floating ohmic contact 224 ($D_{FO}$) is considered to be a distance between a first edge and a second edge of the floating ohmic contact 224. Accordingly, the length of the floating ohmic contact 224 ($D_{FO}$) may be in any suitable range.

As with the distance between the first gate electrode 228 and the floating ohmic contact 224 ($D_{G1-FO}$), a distance between the floating ohmic contact 224 and the second gate electrode 230 ($D_{FO-G2}$) is measured, horizontally, from an outer edge of the floating ohmic contact 224, closest to the second gate electrode 230, to the middle point of the second gate electrode 230 over the top surface of the body region 212. In this regard, the distance between the floating ohmic contact 224 and the second gate electrode 230 ($D_{FO-G2}$) may have any suitable minimum value and any suitable maximum value. Lastly, distance between the second gate electrode 230 and the drain electrode 236 ($D_{G2-D}$) is measured horizontally, at least in this example, from a middle point of the second gate electrode 230 to an outer edge of the drain electrode 236, which may be in any suitable range.

In this manner, a distance between the first gate electrode 228 and the second gate electrode 230 ($D_{G1-G2}$), as shown in FIG. 2, is measured horizontally from the middle point of the first gate electrode 228 to the middle point of the second gate electrode 230, which equals the sum of the distance between the first gate electrode 228 and the floating ohmic contact 224 ($D_{G1-FO}$), the length of the floating ohmic contact 224 ($D_{FO}$), and the distance between the floating ohmic contact 224 and the second gate electrode 230 ($D_{FO-G2}$).

The introduction of the floating ohmic contact 224 between the first gate electrode 228 and the second gate electrode 230 is particularly advantageous. The floating ohmic contact 224 eliminates resistive losses between the first gate electrode 228 and the second gate electrode 230 through establishing a conductive path between a first two-dimensional electron gas (2DEG) or a first channel (not shown) formed under the first gate electrode 228 and a second 2DEG or a second channel (not shown) formed under second gate electrode 230. In this manner, any limitation for a minimum distance required between the first gate electrode 228 and the second gate electrode 230 is eliminated without any reduction in peak performance capability due to an increased distance between the first gate electrode 228 and the second gate electrode 230.

Therefore, the inclusion of the floating ohmic contact 224 in the body region 212 and between the first gate electrode 228 and the second gate electrode 230 enables the distance between the first gate electrode 228 and the second gate electrode 230 ($D_{G1-G2}$) to be increased while maintaining peak device performance capabilities. Increasing the distance between the first gate electrode 228 and the second gate electrode 230 ($D_{G1-G2}$) is particularly advantageous in that it allows for an improved thermal isolation between channels (not shown) formed under the first gate electrode 228 and the second gate electrode 230. Furthermore, increasing $D_{G1-G2}$ enables a heat generated in the body region 212 to be dissipated at an increased rate due to a thermal conduction path with higher thermal conductivity offered by the floating ohmic contact 224, which further enables reducing a die area used for a fabrication of the quasi-dual-gate FET structure 200.

Returning to FIG. 2, the quasi-dual-gate FET structure 200 may further comprise a third passivation layer 238 that is deposited over exposed surfaces of the second passivation layer 232 and at least partially over surfaces of the source electrode 234 and the drain electrode 236 such that a top surface of the source electrode 234 and a top surface of the drain electrode 236 remain exposed. In an embodiment, the quasi-dual-gate FET structure 200 comprises a field plate 240 that connects to the top surface of the source electrode 234, is disposed on and extends over exposed surfaces of the third passivation layer 238 such that the first gate electrode 228 and the second gate electrode 230 are covered underneath the field plate 240. In this manner a single conductive path is formed to connect to and extend from the source electrode 234, such that the first gate electrode 228 and the second gate electrode 230 are covered and encapsulated by the field plate 240, in addition to the second passivation layer 232 and the third passivation layer 238.

The implementation of the field plate 240 over the channel is advantageous in that it reduces the electric field, particularly in areas above the first gate electrode 228 and the second gate electrode 230, which enhances a breakdown voltage associated with the quasi-dual-gate FET structure 200 performing a cascode function. In this regard, the electric field between each of the first gate electrode 228 and the source ohmic contact 220, the first gate electrode 228 and the floating ohmic contact 224, the second gate electrode 330 and the floating ohmic contact 224, and the second gate electrode 230 and the drain ohmic contact 222 is spread out by the field plate 240.

The quasi-dual-gate FET structure 200, as shown in FIG. 1A2, further comprises a fourth passivation layer 242 that is deposited over a top surface of the field plate 240 and over exposed portions of the top surface of the third passivation layer 238 such that a top surface of the field plate 240 above the source electrode 234 and the top surface of the drain electrode 236 remain exposed.

It is to be understood that while the quasi-dual-gate FET structure 200 as shown in FIG. 2 and as described herein pertains to a HEMT semiconductor device, the scope of the present disclosure is not so limited. In this regard, features of the present disclosure may be utilized using other three-terminal active devices, for example, other types of FET semiconductor devices, including but not limited to, metal oxide semiconductor field-effect transistors (MOSFETs), metal insulator field-effect transistors (MISFETs), metal semiconductor field-effect transistor (MESFETs), junction field-effect transistor (JFETs), insulated-gate bipolar transistors (IGBTs), or the like.

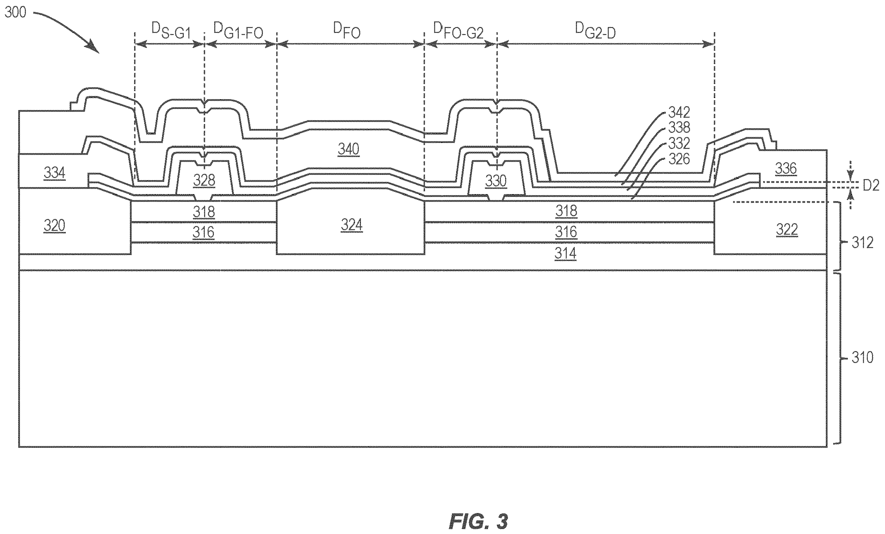

FIG. 3 shows a cross-sectional view of an example FET structure 300 having a floating ohmic contact 324 and a field plate 340, in accordance with some embodiments.

The quasi-dual-gate FET structure 300 is an IC structure. The auxiliary amplifier 106 shown in FIG. 1A and FIG. 1B is provided as one or more of the FETs shown in the FET structure 300, in accordance with some embodiments. For example, in some embodiments, a single one of the FETs is provided as the auxiliary amplifier 106. In other embodiments, multiple FETs are stacked and coupled in cascode to provide the auxiliary amplifier 106. It should be noted that in other embodiments, the FET is not a quasi-dual-gate structure as shown in FIG. 2 but rather is a single gate structure.

The quasi-dual-gate FET structure 300 may be a HEMT, for example, a quasi-dual-gate HEMT, including a substrate 310 and a body region 312 and configured to implement a cascode function. The body region 312 is disposed over a top surface of the substrate 310 and comprises a buffer layer 314, a channel layer 316, and a barrier layer 318, wherein the barrier layer 318 extends over the channel layer 316, and the channel layer 316 is disposed over the buffer layer 314. In this manner, a top surface of the barrier layer 318 forms a top surface of the body region 312 and a bottom surface of the buffer layer 314 forms a bottom surface of the body region 312.

The quasi-dual-gate FET structure 300 further comprises a source ohmic contact 320, a drain ohmic contact 322, and the floating ohmic contact 324 that form over the top surface of the body region 312 and diffuse downward into the body region 312 by thermal annealing. Next, a first passivation layer 326 is deposited over an outermost surface of the body region 312, including top surfaces of the body region 312, the source ohmic contact 320, the drain ohmic contact 322, and the floating ohmic contact 324. Portions of the first passivation layer 326 are selectively removed, for example, using photolithography, to form contact surfaces into which a first gate electrode 328, a second gate electrode 330, a source electrode 334, and a drain electrode 336 are deposited. In this manner, the first gate electrode 328 and the second gate electrode 330 are formed in, over, and around selectively removed portions of the first passivation layer 326. In this configuration, the first gate electrode 328 forms between the source ohmic contact 320 and the floating ohmic contact 324, and the second gate electrode 330 forms between the floating ohmic contact 324 and the drain ohmic contact 322. A trunk thickness D2 of the auxiliary amplifier 106 (See FIG. 1A) refers to the thickness of the first passivation layer 326. Each of the portions of the body region 312 directly under the gate electrodes 328, 330 is a channel region. The trunk thickness D2 thus refers to the thickness of the dielectric material between a channel region and bottom on the connection structure for the gate electrodes 328, 330. In some embodiments, the trunk thickness D2 thus refers to the thickness of the first filed plate (i.e., Tcap) of the gate and bottom on the connection structure for the gate electrodes 328, 330. Each of the portions of the body region 312 directly under the gate electrodes 328, 330 is a channel region.

The quasi-dual-gate FET structure 300, as shown in FIG. 3, may further comprise a second passivation layer 332 that is deposited over a top surface of the first passivation layer 326, exposed portions of top surfaces of the source ohmic contact 320 and the drain ohmic contact 322, and over exposed surfaces of the first gate electrode 328 and the second gate electrode 330. Upon selective removal of portions of the second passivation layer 332 over top surfaces of the source ohmic contact 320 and the drain ohmic contact 322, through a lift-off or an etching process, metal material is deposited in, over, and around selectively removed portions of the second passivation layer 332 to form the source electrode 334 and the drain electrode 336.

As illustrated, a distance between the source electrode 334 and the first gate electrode 328 ($D_{S-G1}$) is measured horizontally, at least in this example, from an outer edge of the source electrode 334 to a middle point of the first gate electrode 328. In this regard, the distance between the source electrode 334 and the first gate electrode 328 ($D_{S-G1}$) may be any suitable value. Furthermore, a distance between the first gate electrode 328 and the floating ohmic contact 324 ($D_{G1-FO}$) is measured, horizontally, from the middle point of the first gate electrode 328 to an outer edge of the floating ohmic contact 324 over the top surface of the body region 312 that is closest to the first gate electrode 328. In this regard, the distance between the first gate electrode 328 and the floating ohmic contact 324 ($D_{G1-FO}$) may be any suitable value.

As shown in FIG. 3, the length of the floating ohmic contact 324 ($D_{FO}$) is considered to be a distance between a first edge and a second edge of the floating ohmic contact 324. Accordingly, the length of the floating ohmic contact 324 ($D_{FO}$) may be in any suitable range.

As with the distance between the first gate electrode 328 and the floating ohmic contact 324 ($D_{G1-FO}$), a distance between the floating ohmic contact 324 and the second gate electrode 330 ($D_{FO-G2}$) is measured, horizontally, from an outer edge of the floating ohmic contact 324, closest to the second gate electrode 330, to the middle point of the second gate electrode 330 over the top surface of the body region 312. In this regard, the distance between the floating ohmic contact 324 and the second gate electrode 330 ($D_{FO-G2}$) may have any suitable minimum value and any suitable maximum value. Lastly, a distance between the second gate electrode 330 and the drain electrode 336 ($D_{G2-D}$) is measured horizontally, at least in this example, from a middle point of the second gate electrode 330 to an outer edge of the drain electrode 336, which may be in any suitable range.

In this manner, a distance between the first gate electrode 328 and the second gate electrode 330 ($D_{G1-G2}$), as shown in FIG. 3, is measured horizontally from the middle point of the first gate electrode 328 to the middle point of the second gate electrode 330, which equals the sum of the distance between the first gate electrode 328 and the floating ohmic contact 324 ($D_{G1-FO}$), the length of the floating ohmic contact 324 ($D_{FO}$), and the distance between the floating ohmic contact 324 and the second gate electrode 330 ($D_{FO-G2}$).

The introduction of the floating ohmic contact 324 between the first gate electrode 328 and the second gate electrode 330 is particularly advantageous. The floating ohmic contact 324 eliminates resistive losses between the first gate electrode 328 and the second gate electrode 330 through establishing a conductive path between a first two-dimensional electron gas (2DEG) or a first channel (not shown) formed under the first gate electrode 328 and a second 3DEG or a second channel (not shown) formed under second gate electrode 330. In this manner, any limitation for a minimum distance required between the first gate electrode 328 and the second gate electrode 330 is eliminated without any reduction in peak performance capability due to an increased distance between the first gate electrode 328 and the second gate electrode 330.

Therefore, the inclusion of the floating ohmic contact 324 in the body region 312 and between the first gate electrode 328 and the second gate electrode 330 enables the distance between the first gate electrode 328 and the second gate electrode 330 ($D_{G1-G2}$) to be increased while maintaining peak device performance capabilities. Increasing the distance between the first gate electrode 328 and the second gate electrode 330 ($D_{G1-G2}$) is particularly advantageous in that it allows for an improved thermal isolation between channels (not shown) formed under the first gate electrode 328 and the second gate electrode 330. Furthermore, increasing $D_{G1-G2}$ enables a heat generated in the body region 312 to be dissipated at an increased rate due to a thermal conduction path with higher thermal conductivity offered by the floating ohmic contact 324, which further enables reducing a die area used for a fabrication of the quasi-dual-gate FET structure 300.

Returning to FIG. 3, the quasi-dual-gate FET structure 300 may further comprise a third passivation layer 338 that is deposited over exposed surfaces of the second passivation layer 332 and at least partially over surfaces of the source electrode 334 and the drain electrode 336 such that a top surface of the source electrode 334 and a top surface of the drain electrode 336 remain exposed. In an embodiment, the quasi-dual-gate FET structure 300 comprises a field plate 340 that connects to the top surface of the source electrode 334, is disposed on and extends over exposed surfaces of the third passivation layer 338 such that the first gate electrode 328 and the second gate electrode 330 are covered underneath the field plate 340. In this manner a single conductive path is formed to connect to and extend from the source electrode 334, such that the first gate electrode 328 and the second gate electrode 330 are covered and encapsulated by the field plate 340, in addition to the second passivation layer 332 and the third passivation layer 338.

The implementation of the field plate 340 over the channel is advantageous in that it reduces the electric field, particularly in areas above the first gate electrode 328 and the second gate electrode 330, which enhances a breakdown voltage associated with the quasi-dual-gate FET structure 300 performing a cascode function. In this regard, the electric field between each of the first gate electrode 328 and the source ohmic contact 320, the first gate electrode 328 and the floating ohmic contact 324, the second gate electrode 330 and the floating ohmic contact 324, and the second gate electrode 330 and the drain ohmic contact 322 is spread out by the field plate 340.

The quasi-dual-gate FET structure 300, as shown in FIG. 1A, further comprises a fourth passivation layer 342 that is deposited over a top surface of the field plate 340 and over exposed portions of the top surface of the third passivation layer 338 such that a top surface of the field plate 340 above the source electrode 334 and the top surface of the drain electrode 336 remain exposed.

It is to be understood that while the quasi-dual-gate FET structure 300 as shown in FIG. 3 and as described herein pertains to a HEMT semiconductor device, the scope of the present disclosure is not so limited. In this regard, features of the present disclosure may be utilized using other three-terminal active devices, for example, other types of FET semiconductor devices, including but not limited to, MOSFETs, MISFETs, MESFETs, JFETs, IGBTs, or the like.

Referring now to FIG. 1A, FIG. 2, and FIG. 3, the Doherty amplifier 100 has a trunk thickness D1 and a trunk thickness D2 selected to improve the efficiency of the Doherty amplifier 100 when the RF signal 102 is a modulated signal while performing wide band operations (e.g., 5G NR signal at 3.7GHz with 600MHz bandwidth). By selecting the trunk thickness D1 and the trunk thickness D2, load-pull contours of the main amplifier 104 and the auxiliary amplifier 106 are determined so that the main amplifier 104 and the auxiliary amplifier 106 maintain high efficiency with modulated signal over wide frequency band. Wide band is defined as having fractional bandwidth (=100 X bandwidth/Center_frequency) greater than 5% In particular, selecting the trunk thicknesses D1, D2 establish the impedances $Z_{EFFM}$, $Z_{EFFA}$, $Z_{POWM}$, $Z_{POWA}$, $Z_{MOD}$, $Z_{OPTM}$, $Z_{OPTA}$

$Z_{EFFM}$ is a load impedance of the main amplifier that results in maximum power efficiency.

$Z_{EFFA}$ is a load impedance of the auxiliary amplifier that results in maximum power efficiency.

$Z_{POWM}$ is a load impedance of the main amplifier that results in maximum power.

$Z_{POWA}$ is a load impedance of the auxiliary amplifier that results in maximum power.

$Z_{MOD}$ is a load impedance of the main amplifier at a target average power with highest power efficiency.

$Z_{OPTM}$ is a load impedance of the main amplifier at saturated output power.

$Z_{OPTA}$ is a load impedance of the auxiliary amplifier at saturated output power.

To define the relationships between the impedances, the concept of Voltage Standing Wave Ratio (VSWR) is used. Voltage Standing Wave Ratio (VSWR) is a parameter that is used in this context as a figure of merit to determine how close two impedances (as complex variables) are. VSWR between two Impedances, $Z_1$ and $Z_2$ is defined as:

$$VSWR_{Z_2-Z_1} = \frac{1 + |\frac{Z_2 - Z_1}{Z_2 + Z_1}|}{1 - |\frac{Z_2 - Z_1}{Z_2 + Z_1}|}$$

Based on this equation, $VSWR_{Z_2-Z_1}$ = 1 when $Z_2 = Z_1$.

The trunk thickness D1 is set such that a difference between $Z_{MOD}$ and $Z_{EFFM}$ is minimized and such that a difference between $Z_{OPTM}$ and $Z_{POWM}$ is minimized. Ideally, the trunk thickness D1 is set so that $Z_{MOD}$ and $Z_{EFFM}$ are substantially equal and so that $Z_{OPTM}$ and $Z_{POWM}$ are substantially equal.

To practically meet the specification that the main amplifier have maximum efficiency at $Z_{MOD}$, one can choose the trunk thickness D1 to thereby choose $Z_{MOD}$ so that that ($1 \leq VSWR_{Z_{MOD}-Z_{EFFM}} \leq 1.3$). With regards to the $VSWR_{Z_{MOD}-Z_{EFFM}}$, the $VSWR_{Z_{MOD}-Z_{EFFM}}$ is equal to:

$$VSWR_{Z_{MOD}-Z_{EFFM}} = \frac{1 + |\frac{Z_{MOD} - Z_{EFFM}}{Z_{MOD} + Z_{EFFM}}|}{1 - |\frac{Z_{MOD} - Z_{EFFM}}{Z_{MOD} + Z_{EFFM}}|}$$

To practically meet the specification that the main amplifier delivers maximum power at $Z_{OPTM}$, where the VSWR relative to $Z_{MOD}$ is determined by peak to average ratio (PAR) of the modulated signal. To meet this requirement, also choose the trunk thickness D1 to choose $Z_{OPTM}$ in such a way that $10^{\frac{PAR}{20}} - 0.3 \leq VSWR_{Z_{OPTM}-Z_{MOD}} \leq 10^{\frac{PAR}{20}} + 0.3$ and such that $1 \leq VSWR_{Z_{OPTM}-Z_{POWM}} \leq 1.3$ ).. For example, for PAR=8.6dB then $2.4 \leq VSWR_{Z_{OPTM}-Z_{MOD}} \leq 3$ and $1 \leq VSWR_{Z_{OPTM}-Z_{POWM}} \leq 1.3$ ).

With regards to the $VSWR_{Z_{OPTM}-Z_{MOD}}$, the $VSWR_{Z_{OPTM}-Z_{MOD}}$ is equal to:

$$VSWR_{Z_{OPTM}-Z_{MOD}} = \frac{1 + |\frac{Z_{OPTM} - Z_{MOD}}{Z_{OPTM} + Z_{MOD}}|}{1 - |\frac{Z_{OPTM} - Z_{MOD}}{Z_{OPTM} + Z_{MOD}}|}$$

With regards to the $VSWR_{Z_{OPTM}-Z_{POWM}}$, the $VSWR_{Z_{OPTM}-Z_{POWM}}$ is equal to:

$$VSWR_{Z_{OPTM}-Z_{POWM}} = \frac{1 + |\frac{Z_{OPTM} - Z_{POWM}}{Z_{OPTM} + Z_{POWM}}|}{1 - |\frac{Z_{OPTM} - Z_{POWM}}{Z_{OPTM} + Z_{POWM}}|}$$

Furthermore, the trunk thickness D2 is set such that a difference between $Z_{POWA}$ and $Z_{EFFA}$ is minimized. Ideally, the difference between $Z_{POWA}$ and $Z_{EFFA}$ cannot be completely eliminated such that $Z_{POWA}$ and $Z_{EFFA}$ are set to be substantially equal. To meet this requirement practically, one can choose the trunk thickness D2 so that $1 \leq VSW R_{Z_{EFFA}-Z_{POWA}} \leq 3$ and such that $1 \leq VSW R_{Z_{OPTA}-Z_{POWA}} \leq 1.7$. $VSW R_{Z_{EFFA}-Z_{POWA}}$ should be as small as possible. The $VSW R_{Z_{EFFA}-Z_{POWA}}$ should be set to be as close to one as possible, in accordance with some embodiments. Ideally, $Z_{OPTA}$ is equal to $Z_{EFFA}$ and $Z_{POWA}$. With regards to the $VSW R_{Z_{EFFA}-Z_{POWA}}$, the $VSW R_{Z_{EFFA}-Z_{POWA}}$ is equal to:

$$VSWR_{Z_{EFFA}-Z_{MOD}} = \frac{1 + |\frac{Z_{EFFA} - Z_{POWA}}{Z_{EFFA} + Z_{POWA}}|}{1 - |\frac{Z_{EFFA} - Z_{POWA}}{Z_{EFFA} + Z_{POWA}}|}$$

With regards to the $VSW R_{Z_{OPTA}-Z_{POWA}}$, the $VSW R_{Z_{OPTA}-Z_{POWA}}$ is equal to:

$$VSWR_{Z_{EFFA}-Z_{MOD}} = \frac{1 + |\frac{Z_{OPTA} - Z_{POWA}}{Z_{OPTA} + Z_{POWA}}|}{1 - |\frac{Z_{OPTA} - Z_{POWA}}{Z_{OPTA} + Z_{POWA}}|}$$

In some embodiments, the Doherty amplifier 100 is configured to amplify the RF signal 102 when the RF signal 102 is a modulated signal. The modulated signal has a peak to average power ratio value. The peak to average power ratio (PAR) is defined as the highest instantaneous power level of the signal compared to the average power of the signal. The peak to average power ratio value is the value of the peak to average power ratio of the modulated signal. In some embodiments, the peak to average power ratio value is between 6dB and 12dB. In some embodiments, the peak to average power ratio value is substantially 8.6 decibels.

In some embodiments, the voltage standing wave ratio between $Z_{OPTM}$ and $Z_{MOD}$ is set in accordance with peak to average power ratio value of the modulated signal. In some embodiments, a voltage standing wave ratio between $Z_{POWA}$ and $Z_{MOD}$ is set to approximately 2.7:1. The impedances and values discussed above are set by selecting the trunk thickness D1 and the trunk thickness D2. In some embodiments, the trunk thickness D1 is selected to be within a range 200 Angstrom - 1700 Angstrom. In some embodiments, the trunk thickness D2 is selected to be within a range 200 Angstrom - 1700 Angstrom. In some embodiments, the trunk thickness D1 is substantially between 200 and 600 Angstroms and the trunk thickness D2 is between 700 and 1400 Angstroms. In some embodiments, the trunk thickness D1 is substantially 700 Angstroms and the trunk thickness D2 is between 700 and 1400 Angstroms. In some embodiments, the trunk thickness D1 is substantially between 200 and 600 Angstroms and the trunk thickness D2 is between 200 and 600 Angstroms.

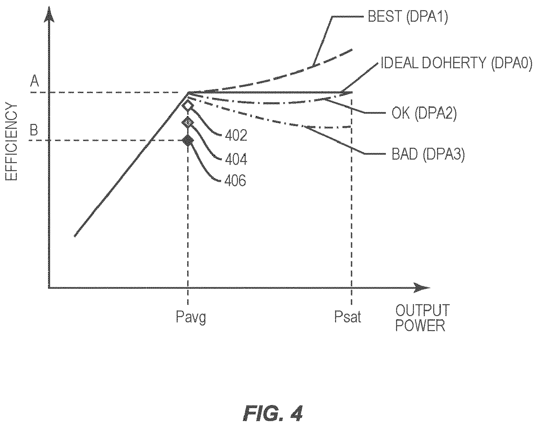

FIG. 4 explains the advantages of selecting the trunk thickness D1 and the trunk thickness D2 so that the Doherty amplifier 100 operates so as to have a better performance when amplifying the RF signal 102 that is modulated signal and a wide band signal.

Efficiency at the average power level $P_{avg}$ (also called output back-off power) is defined by the efficiency of the main amplifier 104. In some embodiments, the main amplifier 104 is biased as a class AB amplifier. However, when the Doherty amplifier 100 is operating above the average power level, both the main amplifier 104 and the auxiliary amplifier 106 are providing amplification to the RF signal 102. In some embodiments, the auxiliary amplifier 106 is a class C amplifier biased so that the auxiliary amplifier 106 begins to provide amplification once the RF signal 102 is provided above a signal level corresponding to the average power level $P_{avg}$. In some embodiments, only the main amplifier 104 is ON at $P_{out} \leq P_{avg}$ and both the main amplifier 104 and auxiliary amplifiers are ON at $P_{out} \geq P_{avg}$. The load impedance seen by the main amplifier 104 is changing as a function of output power Pout. The load impedances of main amplifier at the average power level $P_{avg}$ and at a saturated power level $P_{sat}$ correspond to $Z_{MOD}$ and $Z_{OPTM}$, respectively.

FIG. 4 is a graph demonstrating possible curves DPA1, DPA2, DPA3, DPA4 of efficiency versus output power for the Doherty amplifier 100 when the RF signal 102 is a continuous wave signal or a pulsed continuous wave signal along with dots demonstrating possibilities of the efficiency performance of the Doherty amplifier 100 at the average power level $P_{avg}$ when the RF signal 102 is a modulated signal, in accordance with some embodiments.

In an ideal Doherty amplifier, the power efficiency remains constant between $P_{avg}$ and $P_{sat}$. This is shown by power efficiency curve DPA0. In a practical Doherty amplifier, the power efficiency may not remain constant between $P_{avg}$ and $P_{sat}$. Thus, the performance of a Doherty amplifier can be provided like any of the power efficiency curves DPA1, DPA2, DPA3, when amplifying an RF signal that is a continuous wave (CW) or pulsed-CW RF signal. Clearly, it is best when the Doherty amplifier 100 operates in accordance with the power efficiency curve DPA1.

However, dots 402, 404, 406 represent the possible power efficiency of a practical Doherty amplifier at $P_{avg}$ when Doherty amplifier is amplifying a modulated signal. Clearly, the dots 402, 404, 406 demonstrate that the power efficiency of the Doherty amplifier is lowered at $P_{avg}$ when amplifying a modulated signal. To provide the best power efficiency, it is best that the Doherty amplifier 100 operate in accordance with the dot 402 at $P_{avg}$. A practical non-ideal Doherty amplifier does not have the same efficiency at $P_{sat}$ or any power level between $P_{avg}$ and $P_{sat}$. At first glance, one can easily eliminate the behavior shown by power efficiency curve DPA3, claiming that the other two power efficiency curves DPA1, DPA2 have same or better performance as in ideal Doherty DPA0 at both $P_{avg}$ and $P_{sat}$. This conclusion is acceptable for amplification performance while amplifying CW or pulsed-CW RF signal. However, power efficiency curve DPA1 and power efficiency curve DPA2 result in different efficiencies at $P_{avg}$ when operating with a modulated signal (see dots 402, 404 respectively). The power efficiency curve DPA1 and the dot 402 show higher power efficiency compared to the power efficiency curves DPA2, DPA 3 and dots 404, 406 as the power efficiency is higher at Pout $\geq P_{avg}$.

This behavior can be further explained by the fact that power (or amplitude) of modulated signal is at or around $P_{avg}$ most of time, while it's at $P_{sat}$ only for a very short time. By selecting the trunk thicknesses D1, D2, the Doherty amplifier 100 is operated in accordance with power efficiency curve DPA1 and the dot 402 at $P_{avg}$.

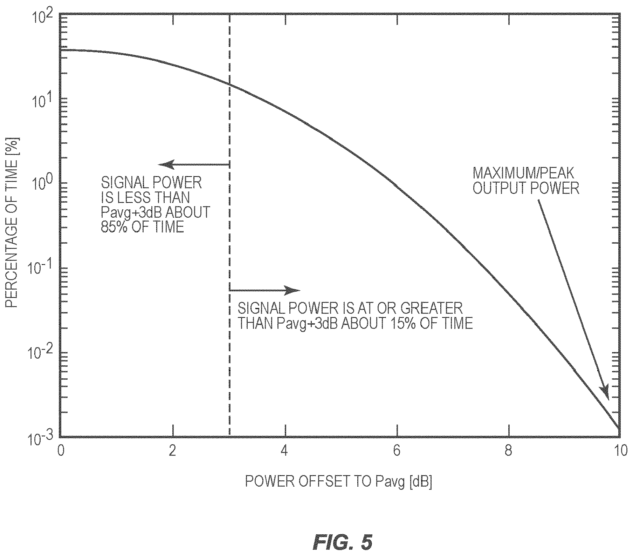

FIG. 5 is the complementary cumulative distribution function (CCDF) of a modulated signal (with peak-to-average ratio (PAR) of 10dB) plotted as a function of power, in accordance with some embodiments.

Specifically, the horizontal axis shows the power offset to $P_{avg}$ in dB where 0dB and 10dB represents $P_{avg}$ and $P_{sat}$, respectively. The CCDF shows the percentage of the time that the modulated signal is at or above a specific power level. The power efficiency behavior shown in FIG. 4 can be explained by the fact that power (or amplitude) of the modulated signal is at or around $P_{avg}$ most of time, while it's at $P_{sat}$ only for a very short time, as shown by FIG. 5. In this example, the power of modulated signal is a) 37% of the time at $P_{out}$ greater than $P_{avg}$, b) about 0.001% of the time at $P_{sat}$ or higher, c) about 15% of the time at $P_{out}$ greater than Pavg+3dB, and d) 85% of the time at $P_{out}$ less than Pavg+3dB. Accordingly, DPA efficiency with modulated signal is close to the average of DPA efficiency which is characterized with pulsed-CW or CW signal around $P_{avg}$ (e.g., $\pm$3dB).

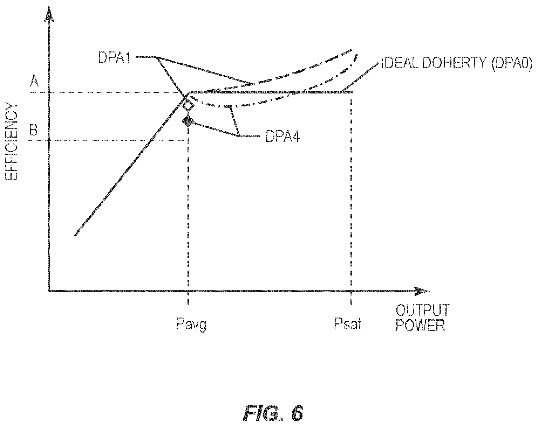

FIG. 6 illustrates another example of a graph illustrating the power efficiency of a Doherty amplifier, in accordance with some embodiments.

Power efficiency curve DPA1 and power efficiency curve DPA4 in FIG. 6 correspond illustrate represent practical DPA curves when a Doherty amplifier is amplifying CW or pulsed-CW RF signals. The dot 502 and 504 represent the power efficiency of Doherty amplifiers when amplifying modulated signals at $P_{avg}$. In the pulsed-CW characterization shown by power efficiency curves DPA1, DPA4, both of the Doherty power amplifiers have the same efficiency at $P_{avg}$ and $P_{sat}$ but DPA4 has lower efficiency at power levels slightly higher than $P_{avg}$. Therefore, DPA4 at the dot 504 shows lower efficiency compared to DPA1 at the dot 502 when characterized with the modulated signal. Thus, to achieve the optimum performance, like in DPA1, both the trunk thickness D1 of the main amplifier 104 and the trunk thickness D2 of the auxiliary amplifier 106 should be designed to meet target efficiency at $P_{avg}$, $P_{sat}$ and power levels around $P_{avg}$.

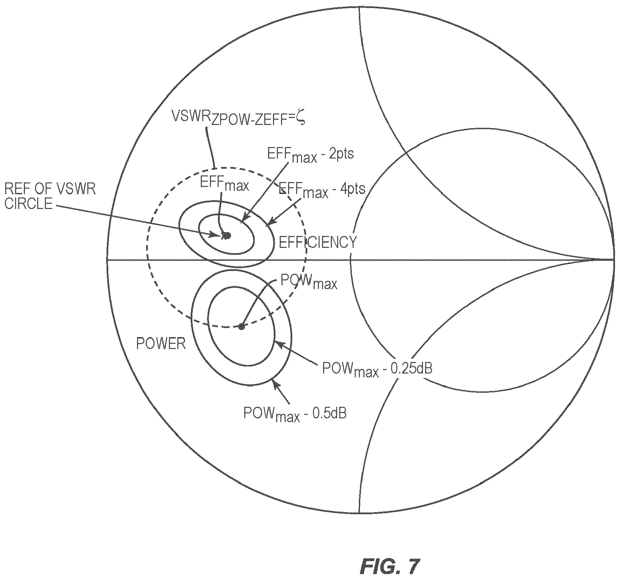

FIG. 7 illustrates LP contours of the main amplifier 104 in FIG. 1A on a Smith chart, in accordance with some embodiments.

In order for $Z_{MOD}=Z_{EFFM}$ and for $Z_{OPTM}=Z_{POWM}$, $Z_{MOD}$ and $Z_{OPTM}$ is provided at $EFF_{MAX}$ and at $POW_{MAX}$, respectively. To achieve this the VSWR between the $Z_{MOD}$ and $Z_{OPTM}$ is set in accordance with peak to average ratio value of the applicable modulated signal by selecting the trunk thickness D1 (See FIG. 2). In one example where PAR of the modulated signal is 8.6dB, the VSWR between the $Z_{MOD}$ and $Z_{OPTM}$ is set to 2.7 (VSWR=$10^{PAR/20}$) to ensure that the main amplifier 104 has maximum efficiency at $P_{avg}$ (with the load impedance of $Z_{MOD}$) and maximum power at $P_{sat}$ (with the load impedance of $Z_{OPTM}$).

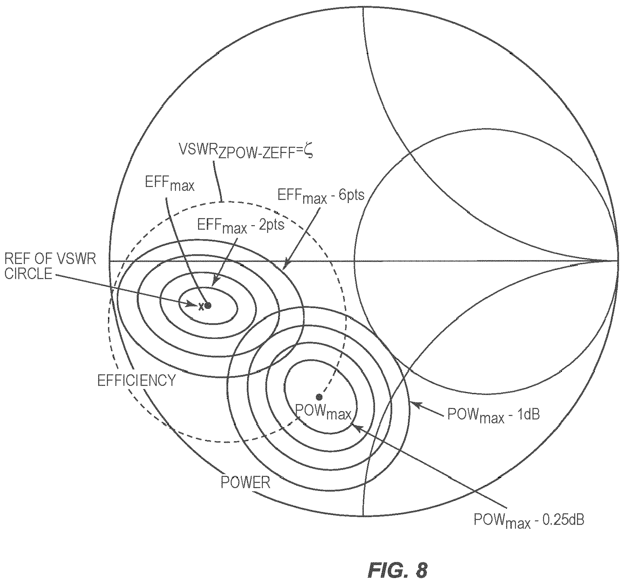

FIG. 8 illustrates LP contours of the auxiliary amplifier 106 in FIG. 1A on a Smith chart, in accordance with some embodiments.

In an ideal circumstance, $Z_{EFFA}$ (e.g., $EFF_{MAX}$) and $Z_{POWA}$ are on top of each other so that the VSWR between $Z_{POWA}$ and $Z_{EFFA}$ is equal to one. However, actually getting the VSWR between $Z_{POWA}$ and $Z_{EFFA}$ is not practical, in some embodiments. Thus, the trunk thickness D2 is selected to minimize the VSWR between $Z_{POWA}$ and $Z_{EFFA}$ and achieve highest efficiency at $Z_{POWA}$ with minimum drop compared with efficiency at $Z_{EFFA}$. In some embodiments, the trunk thickness D2 so that $1 \leq VSWR_{Z_{EFFA}\text{-}Z_{POWA}} \leq 3$.

In one example, trunk thickness D2 is set between 700 and 1400 Angstroms to achieve a VSWR between $Z_{POWA}$ and $Z_{EFFA}$ of about 2:1 for the auxiliary amplifier 106. Although it is not the ideal value of one, it is good enough to improve asymmetric DPA performance, from DPA3 to DPA1, and achieve much higher efficiency at $P_{avg}$ with a modulated signal. Likewise, the trunk thickness D1=D2 in this example is set so that the VSWR between the $Z_{MOD}$ and $Z_{OPTM}$ is about 2. This makes the main amplifier 104, designed in the same process, suboptimal.

In one example, trunk thickness D1 is set between 200 and 600Angstroms to achieve $VSW\,R_{Z_{OPTM}-Z_{MOD}}$ of about 2.7 for the main amplifier 104. In some embodiments, the trunk thickness D1 of between 200 and 600 Angstroms is the optimum value when the main amplifier 104 is implemented in an asymmetric (with auxiliary to main periphery ratio 1.7-to-1) Doherty amplifier operating with modulated signal with PAR=8.6dB. On the other hand, the periphery of auxiliary amplifier 106 is to be 1.7 times the periphery of the main amplifier 104 to achieve target $P_{sat}$ in this asymmetric Doherty power amplifier. However, $VSW\,R_{Z_{EFFA}-Z_{POWA}}$ in this example, is about 2.8 which results in efficiency at $Z_{POWA}$ to be much less than efficiency at $Z_{EFFA}$. Therefore, Doherty amplifier has a poor efficiency at $P_{sat}$, although it has the optimum performance $P_{avg}$ when operating with pulsed-CW signal.

In order to achieve an enhanced performance (like DPA1), the trunk thickness for the main amplifier 104 is between 200 and 600 Angstroms while the trunk thickness of the auxiliary amplifier 106 is between 700 and 1400 Angstroms, respectively.

Trunk thickness D1, D2 for the main amplifier 104 and the auxiliary amplifier 106 can be optimized based on the application of the Doherty amplifier 100. A range of the trunk thickness D1 and a range of the trunk thickness D2 are governed by limitations in process integration.

In one example, trunk thickness D1 and the trunk thickness D2 are both set between 700 and 1400 Angstroms in a symmetric Doherty amplifier (1:1), where the Doherty amplifier 100 is amplifying a modulated signal with a PAR=6dB.

In one example, the trunk thickness D1 can be less than 200 Angstroms for the main amplifier 104 and greater than 1400 Angstroms for the auxiliary amplifier 106 when the Doherty amplifier 100 amplifies a modulated signal having a PAR≥8.6dB.

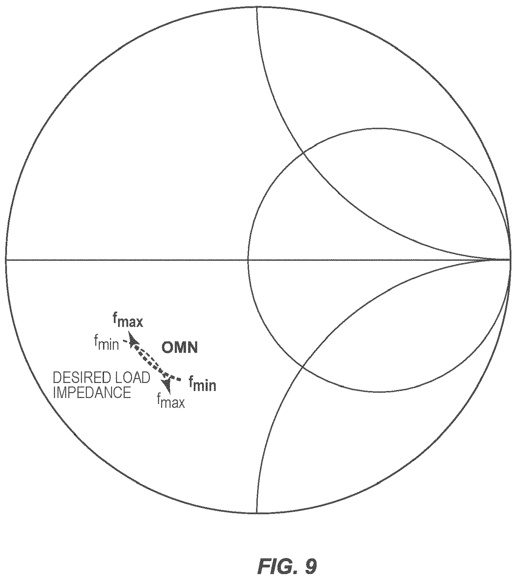

FIG. 9 illustrates the load impedance provided by an output matching network and a target load impedance for the Doherty amplifier 100 on a Smith chart, in accordance with some embodiments.

As shown in FIG. 9, the load impedance provided by the output matching network (OMN) is changing with operating frequency. The load impedance provided by the OMN typically rotates clockwise on the Smith chart as frequency increases. On the other hand, the target load impedance for the main amplifier 104 and the auxiliary amplifier 106 rotates counterclockwise with increasing frequency. This behavior leads to performance degradation in wide band (WB) applications.

To minimize the impact of load impedance rotation over frequency, an optimum load area can be defined in such a way that change in load impedance does not result in a significant degradation in efficiency (e.g., at $Z_{MOD}$) or power (e.g., at $Z_{OPTM}$ and $Z_{OPTA}$).

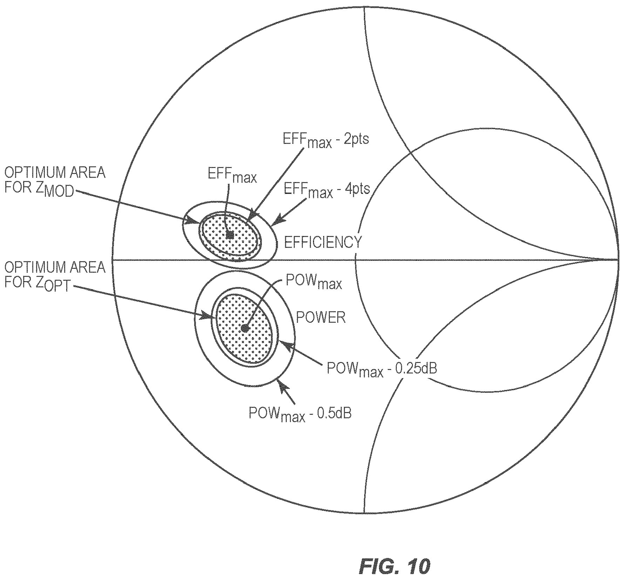

FIG. 10 illustrates the optimum areas for $Z_{MOD}$ and $Z_{OPTM}$ for the main amplifier 104 of FIG. 1, in accordance with some embodiments.

In FIG. 10, the optimum area for $Z_{MOD}$ is where $Z_{MOD}$ equals $Z_{EFFM}$, so load change will not result in more than 2 points drop in efficiency. Accordingly, optimum area for $Z_{OPTM}$ is where $Z_{OPTM}$ equals $Z_{EFFM}$, so load change will not result in more than 0.25dB drop in power. Both specifications are aligned with $Z_{MOD}=Z_{EFFM}$ and $Z_{OPTM}=Z_{POWM}$. In some embodiments, $(1 \leq VSW\,R_{Z_{MOD}-Z_{EFFM}} \leq 1.3)$.

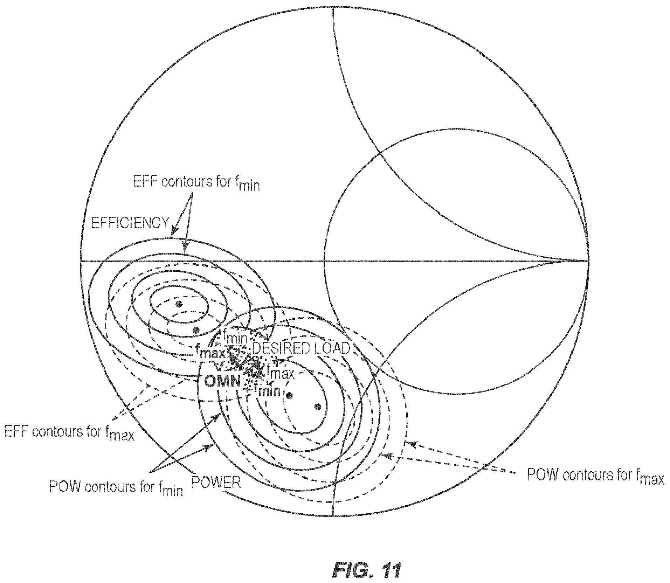

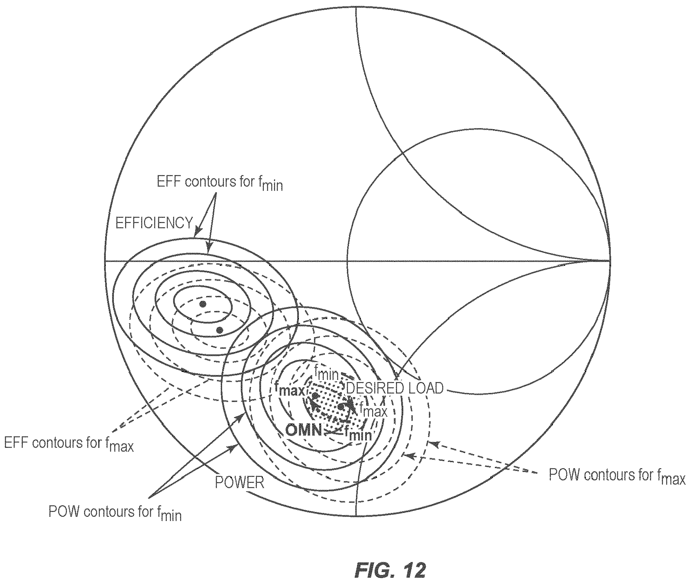

FIG. 11 illustrates non-optimum load areas and FIG. 12 illustrates optimum load areas for the auxiliary amplifier 106, shown in FIG. 1A and FIG. 1B.

In FIG. 11, the desired load impedance trajectory is located between $Z_{EFFM}$ and $Z_{POWM}$. It leads to a significant slope in efficiency of the Doherty amplifier at $P_{sat}$ as load impedance, provided by output matching network (OMN), results in lower efficiency and higher power at a minimum frequency fmin, and higher efficiency and lower power at the maximum frequency fmax. In FIG. 12, the desired load impedance trajectory is located close to $Z_{POWM}$ at the minimum frequency fmin and the maximum frequency fmax, so almost the same power can be maintained at $P_{sat}$ over the frequency range fmin to fmax. Although there is a slope in efficiency of the Doherty amplifier 100 at $P_{sat}$, it can be minimized by following the proposed method to minimize the VSWR between $Z_{POWM}$ and $Z_{EFFM}$. In some embodiments, $1 \leq VSW\,R_{Z_{EFFM}-Z_{POWM}} \leq 2.3$

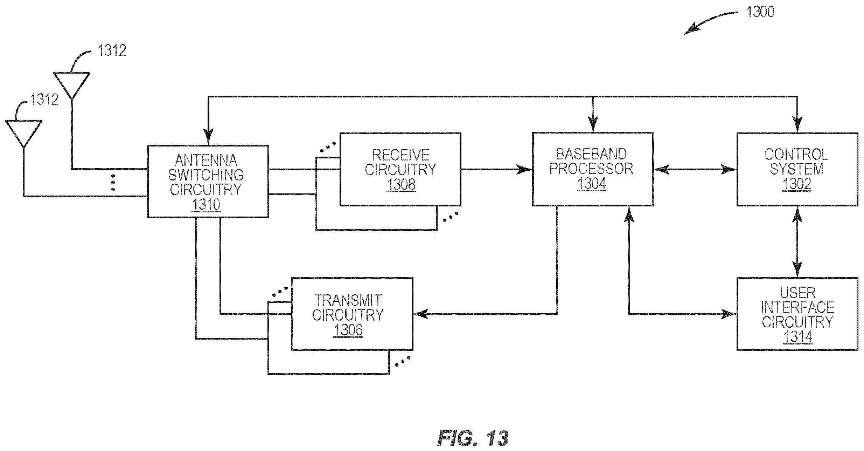

With reference to Figure 13, the concepts described above may be implemented in various types of user elements 1300, such as mobile terminals, smart watches, tablets, computers, navigation devices, access points, and like wireless communication devices that support wireless communications, such as cellular, wireless local area network (WLAN), Bluetooth, and near field communications.

The user element 1300 will generally include a control system 1302, a baseband processor 1304, transmit circuitry 1306, receive circuitry 1308, antenna switching circuitry 1310, multiple antennas 1312, and user interface circuitry 1314. In a non-limiting example, the control system 1302 may be a field-programmable gate array (FPGA) or an application-specific integrated circuit (ASIC). In this regard, the control system 1302 may include at least a microprocessor(s), an embedded memory circuit(s), and a communication bus interface(s). The receive circuitry 1308 receives radio frequency signals via the antennas 1312 and through the antenna switching circuitry 1310 from one or more base stations. A low noise amplifier and a filter cooperate to amplify and remove broadband interference from the received signal for processing. Downconversion and digitization circuitry (not shown) will then downconvert the filtered, received signal to an intermediate or baseband frequency signal, which is then digitized into one or more digital streams using analog-to-digital converter(s) (ADC).

The baseband processor 1304 processes the digitized received signal to extract the information or data bits conveyed in the received signal. This processing typically comprises demodulation, decoding, and error correction operations, as will be discussed in greater detail below. The baseband processor 1304 is generally implemented in one or more digital signal processors (DSPs) and application specific integrated circuits (ASICs).

For transmission, the baseband processor 1304 receives digitized data, which may represent voice, data, or control information, from the control system 1302, which it encodes for transmission. The encoded data is output to the transmit circuitry 1306, where a digital-to-analog converter(s) (DAC) converts the digitally encoded data into an analog signal and a modulator modulates the analog signal onto a carrier signal that is at a desired transmit frequency or frequencies. A power amplifier will amplify the modulated carrier signal to a level appropriate for transmission and deliver the modulated carrier signal to the antennas 1312 through the antenna switching circuitry 1310. The multiple antennas 1312 and the replicated transmit and receive circuitries 1306, 1308 may provide spatial diversity. Modulation and processing details will be understood by those skilled in the art.

Therefore, from one perspective, there have been described approaches for a Doherty amplifier. In some embodiments, the Doherty amplifier includes: a main amplifier defining a first trunk thickness; an auxiliary amplifier defining a second trunk thickness. Impedances of the Doherty amplifier are set by selecting the first trunk thickness of the main amplifier and the second trunk thickness of the auxiliary amplifier. In this manner, the power efficiency of the Doherty amplifier is improved when amplifying a modulated signal.

Further examples are set out in the following numbered clauses.

Clause 1. An integrated circuit (IC) amplification device, comprising: a Doherty amplifier comprising: a main amplifier defining a first trunk thickness; and an auxiliary amplifier defining a second trunk thickness; wherein: the first trunk thickness is set such that $1 \leq VSWR\_(Z\_MOD-Z\_EFFM) \leq 1.3$ and such that $[10]^\wedge(PAR/20)-0.3 \leq VSWR\_(Z\_OPTM-Z\_MOD) \leq [10]^\wedge(PAR/20)+0.3$, where PAR is a peak to average ratio; and the second trunk thickness is set such that $1 \leq VSWR\_(Z\_EFFA-Z\_POWA) \leq 3$.

Clause 2. The IC structure of clause 1, wherein the Doherty amplifier is configured to amplify a modulated signal having the PAR.

**[0120]** Clause 3. The IC structure of clause 1 or 2, wherein the first trunk thickness is set so that ZMOD and ZEFFM are substantially equal.

Clause 4. The IC structure of clause 1, 2 or 3, wherein the first trunk thickness is set so that ZOPTM and ZPOWM are substantially equal.

Clause 5. The IC structure of any of clauses 1 to 4, wherein: the first trunk thickness is set so that ZMOD and ZEFFM are substantially equal; and the first trunk thickness is set so that ZOPTM and ZPOWM are substantially equal.

Clause 6. The IC structure of any of clauses 1 to 5, wherein: the main amplifier is formed by a field effect transistor comprising: a gate; a passivation layer; a channel region; and the gate being formed on the channel region and extending through the passivation layer, wherein the first trunk thickness is a thickness of the passivation layer.

Clause 7. The IC structure of any of clauses 1 to 6, wherein: the auxiliary amplifier is formed by a field effect transistor comprising: a gate; a passivation layer; a channel region; and the gate being formed on the channel region and extending through the passivation layer, wherein the second trunk thickness is a thickness of the passivation layer.

Clause 8. The IC structure of any of clauses 1 to 7, wherein: the main amplifier is formed by a first field effect transistor comprising: a first gate; a first passivation layer; a first channel region; and the first gate being formed on the first channel region and extending through the first passivation layer, wherein the first trunk thickness is a thickness of the first passivation layer; and the auxiliary amplifier is formed by a field effect transistor comprising: a second gate; a second passivation layer; a second channel region; and the second gate being formed on the second channel region and extending through the second passivation layer, wherein the second trunk thickness is a thickness of the second passivation layer.

Clause 9. The IC structure of clause 8, wherein the first field effect transistor is a first Gallium Nitride transistor and the second field effect transistor is a second Gallium Nitride transistor.

Clause 10. The IC structure of clause 8 or 9, wherein the first trunk thickness is substantially between 200 and 600 Angstroms Angstroms and the second trunk thickness is between 700 and 1400 Angstroms.

Clause 11. The IC structure of clause 10, wherein a voltage standing wave ratio between ZPOWA and ZEFFA is set to approximately 2:1.

Clause 12. The IC structure of clause 11, wherein the Doherty amplifier is configured to receive a modulated signal with a PAR of 6 decibels.

Clause 13. The IC structure of any of clauses 8 to 12, wherein the first trunk thickness is substantially between 700 and 1400 Angstroms and the second trunk thickness is between 700 and 1400 Angstroms.

Clause 14. The IC structure of any of clauses 8 to 13, wherein the Doherty amplifier is configured to receive a modulated signal with a PAR of 8.6 decibels.

Clause 15. An integrated circuit (IC) amplification device, comprising: a Doherty amplifier comprising: a radio frequency (RF) input configured to receive an RF input signal; an RF output; a main amplifier defining a first trunk thickness, wherein the main amplifier has a main amplifier input and a main amplifier output, the main amplifier input is coupled to the RF input; an auxiliary amplifier defining a second trunk thickness, wherein the auxiliary amplifier has an auxiliary amplifier input and an auxiliary amplifier output, the auxiliary amplifier input being coupled to the RF input; a first quarter wave component connected between the RF input and the auxiliary amplifier input; a second quarter wave component connected between the main amplifier output and the RF output; wherein: the first trunk thickness is set such that 1≤VSWR_(Z_MOD-Z_EFFM )≤1.3 and such that [10] ^(PAR/20)-0.3≤VSWR_(Z_OPTM-Z_MOD )≤ [10] ^(PAR/20)+0.3, where PAR is a peak to average ratio; and the second trunk thickness is set such that 1≤VSWR_(Z_EFFA-Z_POWA )≤3.

Clause 16. The IC structure of clause 15, wherein the main amplifier output and the auxiliary amplifier output are coupled to the RF output.

Clause 17. The IC structure of clause 15 or 16, wherein the Doherty amplifier is configured to amplify a modulated signal having the PAR.

**[0135]** Clause 18. The IC structure of clause 15, 16 or 17, wherein the first trunk thickness is set so that ZMOD and ZEFFM are substantially equal.

Clause 19. The IC structure of any of clauses 15 to 18, wherein the second trunk thickness is set so that ZOPTA and ZPOWA are substantially equal.

Clause 20. The IC structure of any of clauses 15 to 19, wherein: the first trunk thickness is set so that ZMOD and ZEFFM are substantially equal; and the first trunk thickness is set so that ZOPTM and ZPOWM are substantially equal.

In conclusion, the disclosed techniques to achieve higher efficiency over wider frequency bands for a Doherty amplifier that amplifies a modulated signal.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

**Claims**

1. An integrated circuit, IC, amplification device, comprising:
   a Doherty amplifier comprising:

   a main amplifier defining a first trunk thickness; and
   an auxiliary amplifier defining a second trunk thickness; wherein:

   the first trunk thickness is set such that $1 \leq VSW\,R_{Z_{MOD}\text{-}Z_{EFFM}} \leq 1.3$ and such that

   $$10^{\frac{PAR}{20}} - 0.3 \leq VSWR_{Z_{OPTM}-Z_{MOD}} \leq 10^{\frac{PAR}{20}} + 0.3$$ , where PAR is a peak to average ratio; and
   the second trunk thickness is set such that $1 \leq VSW\,R_{Z_{EFFA}\text{-}Z_{POWA}} \leq 3$.

2. The IC structure of claim 1, wherein the Doherty amplifier is configured to amplify a modulated signal having the PAR.

3. The IC structure of claim 1 or 2, wherein the first trunk thickness is set so that $Z_{MOD}$ and $Z_{EFFM}$ are substantially equal.

4. The IC structure of claim 1, 2 or 3, wherein the first trunk thickness is set so that $Z_{OPTM}$ and $Z_{POWM}$ are substantially equal.

5. The IC structure of any of claims 1 to 4, wherein:
   the main amplifier is formed by a field effect transistor comprising:

   a gate;
   a passivation layer;
   a channel region; and

the gate being formed on the channel region and extending through the passivation layer, wherein the first trunk thickness is a thickness of the passivation layer.

6. The IC structure of any of claims 1 to 5, wherein:
the auxiliary amplifier is formed by a field effect transistor comprising:

a gate;
a passivation layer;
a channel region; and
the gate being formed on the channel region and extending through the passivation layer, wherein the second trunk thickness is a thickness of the passivation layer.

7. The IC structure of claim 6 when dependent from at least claim 5, wherein the first field effect transistor is a first Gallium Nitride transistor and the second field effect transistor is a second Gallium Nitride transistor.

8. The IC structure of claim 6 when dependent from at least claim 5 or claim 7, wherein the first trunk thickness is substantially between 200 and 600 Angstroms Angstroms and the second trunk thickness is between 700 and 1400 Angstroms.

9. The IC structure of claim 8, wherein a voltage standing wave ratio between $Z_{POWA}$ and $Z_{EFFA}$ is set to approximately 2:1.

10. The IC structure of claim 9, wherein the Doherty amplifier is configured to receive a modulated signal with a PAR of 6 decibels.

11. The IC structure of claim 6 when dependent from at least claim 5 or any of claims 7 to 10, wherein the first trunk thickness is substantially between 700 and 1400 Angstroms and the second trunk thickness is between 700 and 1400 Angstroms.

12. The IC structure of claim 6 when dependent from at least claim 5 or any of claims 7 to 11, wherein the Doherty amplifier is configured to receive a modulated signal with a PAR of 8.6 decibels.

13. The IC structure of any of claims 1 to 12, wherein:

the Doherty amplifier further comprises:

a radio frequency (RF) input configured to receive an RF input signal;
an RF output;
a first quarter wave component connected between the RF input and the auxiliary amplifier input; and
a second quarter wave component connected between the main
amplifier output and the RF output;

wherein:

the main amplifier has a main amplifier input and a main amplifier output, the main amplifier input is coupled to the RF input;
the auxiliary amplifier has an auxiliary amplifier input and an auxiliary amplifier output, the auxiliary amplifier input being coupled to the RF input;

14. The IC structure of claim 13, wherein the main amplifier output and the auxiliary amplifier output are coupled to the RF output.

15. The IC structure of claim 13 or 14, wherein the Doherty amplifier is configured to amplify a modulated signal having the PAR.

**FIG. 1A**

**FIG. 1B**

**FIG. 2**

EP 4 401 322 A1

FIG. 3

**FIG. 4**

EP 4 401 322 A1

*FIG. 5*

FIG. 6

FIG. 7

FIG. 8

*FIG. 9*

FIG. 10

FIG. 11

EFF contours for $f_{min}$

EFFICIENCY

EFF contours for $f_{max}$

$f_{min}$

$f_{max}$

DESIRED LOAD

$f_{max}$

OMN

$f_{min}$

POW contours for $f_{max}$

POWER

POW contours for $f_{min}$

FIG. 12

FIG. 13

Europäisches
Patentamt

European
Patent Office

Office européen
des brevets

# EUROPEAN SEARCH REPORT

**Application Number**

EP 24 15 1253

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 9 966 903 B1 (MCLAREN ROY [US] ET AL) 8 May 2018 (2018-05-08) * abstract * * column 2, line 10 - column 35, line 35 * * figures 1-11 * | 1-15 | INV. H04B1/04 H03F1/02 |
| A | US 2021/013838 A1 (WANG ZHANCANG [CN] ET AL) 14 January 2021 (2021-01-14) * abstract * * paragraphs [0040] - [0075] * * figures 1-14 * | 1-15 | |
| A | RAYMOND S PENGELLY ET AL: "A Review of GaN on SiC High Electron-Mobility Power Transistors and MMICs", IEEE TRANSACTIONS ON MICROWAVE THEORY AND TECHNIQUES, IEEE, USA, vol. 60, no. 6, 1 June 2012 (2012-06-01), pages 1764-1783, XP011445291, ISSN: 0018-9480, DOI: 10.1109/TMTT.2012.2187535 * the whole document * | 1-15 | |

**TECHNICAL FIELDS SEARCHED (IPC)**

H04B
H03F

The present search report has been drawn up for all claims

| Place of search | Date of completion of the search | Examiner |
|---|---|---|
| Munich | 13 May 2024 | Aquilani, Dario |

EPO FORM 1503 03.82 (P04C01)

## ANNEX TO THE EUROPEAN SEARCH REPORT
## ON EUROPEAN PATENT APPLICATION NO.

EP 24 15 1253

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2024

| Patent document cited in search report | | Publication date | Patent family member(s) | | Publication date |
|---|---|---|---|---|---|
| US 9966903 | B1 | 08-05-2018 | US | 9966903 B1 | 08-05-2018 |
| | | | US | 9973150 B1 | 15-05-2018 |
| US 2021013838 | A1 | 14-01-2021 | CN | 111543005 A | 14-08-2020 |
| | | | EP | 3729640 A1 | 28-10-2020 |
| | | | US | 2021013838 A1 | 14-01-2021 |
| | | | WO | 2019119262 A1 | 27-06-2019 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 63511352 A
- WO 63479787 A
- WO 63539384 A
- WO 63513974 A
- WO 63502268 A
- WO 63479790 A
- WO 63479788 A